# EUROPÄISCHE PATENTSCHRIFT

(11) **EP 2 085 836 B1**
(45) Veröffentlichungstag und Bekanntmachung des Hinweises auf die Patenterteilung: **17.04.2019**
(21) Anmeldenummer: 09100047.1
(22) Anmeldetag: 16.01.2009
(51) Int. Cl.: G05B 9/00, G01R 31/327, H01H 47/00, A47L 15/42, D06F 58/26, D06F 39/04

(54) **Schaltungsanordnung zum Betreiben eines Hausgeräts und entsprechendes Verfahren**
Circuit arrangement and method for operating a home appliance
Circuit et procédé pour faire fonctionner un appareil électroménager

(30) Priorität: 29.01.2008 DE 102008006512
(43) Veröffentlichungstag der Anmeldung: 05.08.2009
(73) Patentinhaber: BSH Hausgeräte GmbH, 81739 München (DE)
(72) Erfinder: Bache, Kai-Uwe, 10777 Berlin (DE); Gorny, Piotr, 56-500 Syców (PL); Sattler, Guido, 14612 Falkensee (DE)

(56) Entgegenhaltungen:
- EP-A- 1 594 021
- EP-B1- 1 004 059
- DE-A1- 19 733 533
- DE-A1- 19 755 089
- DE-C1- 19 944 461
- DE-C2- 3 520 257
- JP-A- 62 064 291

## Beschreibung

Die vorliegende Erfindung betrifft ein Hausgerät, insbesondere zur Pflege von Wäschestücken, mit einer Schaltungsanordnung zum Betreiben des Hausgeräts. Überdies bezieht sich die vorliegende Erfindung auf ein entsprechendes Verfahren zum Betreiben eines Hausgeräts.

Unter dem Begriff "Hausgerät" wird hier insbesondere eine Waschmaschine, ein Trockner oder ein Waschtrockner verstanden. Unter den Begriff fallen aber auch andere Arten von Hausgeräten.

Eine Schaltungsanordnung, die zum Betreiben eines Hausgeräts geeignet ist, und ein Verfahren zum Betreiben einer solchen Schaltungsanordnung, welche eine Steuereinheit und mindestens zwei elektrische Verbraucher enthält, die mit einem ersten Eingangsanschluss eines Eingangs der Schaltungsanordnung über einen gemeinsamen, von der Steuereinheit ansteuerbaren Schalter und mit einem zweiten Eingangsanschluss des Eingangs über jeweils einen von der Steuereinheit ansteuerbaren, separaten elektrischen Schalter gekoppelt sind, ist in EP 1 004 059 B1 offenbart. Der Eingang der Steuereinheit ist mit zwei unterschiedlichen Potentialen Ubat und GND gekoppelt und die Steuereinheit hat einen Testeingang, welcher der Gleichspannungsquelle Ubat, GND koppelbar ist.

DE 35 20 257 C2 offenbart eine Schaltungsanordnung eines Fehlererfassungsgeräts zur Betriebsüberwachung eines elektrischen Schaltrelais, dessen Schaltkontakte in einem dreiphasigen Laststromkreis liegen.

Ferner offenbaren DE 197 55 089 A1 eine Sicherheitsschaltung für einen Heizkreis einer Wasch-, Geschirrspülmaschine oder eines Trockners und DE 197 33 533 A1 eine Überwachungsschaltung für eine Steuerung eines Elektromotors, insbesondere eines Wäschetrommelmotors. Beide Schaltungen weisen eine Steuereinheit auf, welche einen Testeingang haben, mittels dem die Zustände von Schaltern überwacht werden können.

Vorliegend gilt das Interesse einem Erkennen einer ordnungsgemäßen Relaisfunktion in einem Hausgerät im Hinblick auf ein sicheres Betreiben des Hausgeräts. In Hausgeräten, und insbesondere in Waschmaschinen, Trocknern und Waschtrocknern, werden üblicherweise Relais zur Ansteuerung von Verbrauchern eingesetzt. Im Sinne der Norm konnten bisher geprüfte Relais eingesetzt werden, wobei eine Fehlersimulation des Relais selbst unter Verwendung geprüfter Bauteile nicht erforderlich war.

Die Aufgabe der vorliegenden Erfindung besteht darin, ein Hausgerät sowie ein Verfahren zum Betreiben des Hausgeräts vorzuschlagen, bei welchem Maßnahmen getroffen sind, welche im Hinblick auf die Sicherheit eine Erkennung der ordnungsgemäßen Funktion eines in dem Hausgerät eingesetzten elektrischen Schalters bzw. eine Erkennung eines fehlerbehafteten Schalters gewährleisten.

Diese Aufgabe wird erfindungsgemäß durch ein Hausgerät mit den Merkmalen gemäß entsprechendem unabhängigem Patentanspruch, sowie durch ein Verfahren mit den Merkmalen gemäß entsprechendem unabhängigem Patentanspruch gelöst.

Vorteilhafte Ausgestaltungen der Erfindung sind in den abhängigen Patentansprüchen angegeben.

Ein erfindungsgemäßes Hausgerät, insbesondere ein Hausgerät zur Pflege von Wäschestücken, ist mit einer Schaltungsanordnung zum Betreiben desselben ausgebildet. Die Schaltungsanordnung umfasst eine Steuereinheit zum Steuern von Prozessen des Hausgeräts, sowie mindestens zwei elektrische Verbraucher, die zumindest einen Elektromotor und eine Heizung umfassen. Dabei sind die elektrischen Verbraucher mit einem ersten Eingangsanschluss eines Eingangs der Schaltungsanordnung über einen gemeinsamen, von der Steuereinheit ansteuerbaren elektrischen Schalter, und mit einem zweiten Eingangsanschluss des Eingangs über jeweils einen, von der Steuereinheit ansteuerbaren separaten elektrischen Schalter gekoppelt. Zwischen dem gemeinsamen Schalter und einem der separaten Schalter ist ein Rückkoppelpol ausgebildet, welcher mit einem Testeingang der Steuereinheit gekoppelt ist.

Ein zentraler Aspekt der vorliegenden Erfindung besteht darin, dass ein gemeinsamer elektrischer Schalter für alle im Hausgerät vorhandenen elektrischen Verbraucher vorgesehen ist, mittels welchem diese von einem ersten Eingangsanschluss eines Eingangs der Schaltungsanordnung bedarfsabhängig koppelbar sind. Ein weiterer Aspekt der Erfindung besteht darin, dass die mindestens zwei im Hausgerät vorhandenen Verbraucher darüber hinaus über jeweils einen separaten elektrischen Schalter mit einem zweiten Eingangsanschluss des Eingangs der Schaltungsanordnung bedarfsabhängig koppelbar sind. Darüber hinaus ist eine Steuereinheit vorgesehen, welche zum Steuern von Prozessen des Hausgeräts ausgebildet ist, und mittels welcher die elektrischen Schalter ansteuerbar sind. In vorteilhafter Weise wird hierdurch erreicht, dass die mindestens zwei elektrischen Verbraucher über einzelne Schalter angesteuert werden können. Überdies besteht ein wesentlicher Gedanke der Erfindung darin, dass die Schaltzustände der Schalter über einen Rückkanal überprüft werden können, was durch ein geschicktes Koppeln eines zwischen dem gemeinsamen Schalter und einem der separaten Schalter ausgebildeten Rückkoppelpol mit einem Testeingang der Steuereinheit erreicht wird. Insbesondere ist so lediglich ein Rückkanal, also eine einzige Rückkopplung für die Prüfung aller vorhandenen elektrischen Schalter hinreichend.

Sind im Hausgerät mindestens zwei elektrische Verbraucher vorhanden, so sind dabei insbesondere drei elektrische Schalter vorgesehen, wobei einer der Schalter als gemeinsamer Schalter ausgebildet ist, welcher die beiden elektrischen Verbraucher mit dem ersten Eingangsanschluss bedarfsabhängig koppelt. Dabei sind die zwei übrigen Schalter insbesondere als separate Schalter ausgebildet, welche jeweils einem der elektrischen Verbraucher zugeordnet sind. Zwischen einem Ersten der separaten Schalter und dem gemeinsamen Schalter ist ein Rückkoppelpol definiert, welcher mit einem Testeingang der Steuereinheit gekoppelt ist. Ist die Schaltungsanordnung an ein Versorgungsnetz über den Eingang angeschlossen, so liegt der erste Eingangsanschluss insbesondere an einem Netzpotential, wobei der zweite Eingangsanschluss vorzugsweise an einem Neutralpotential liegt. Durch das erfindungsgemäße Hausgerät mit der Schaltungsanordnung, und insbesondere durch die intelligente Kopplung des Rückkoppelpols mit der Steuereinheit, ist eine Erkennung einer Fehlerfunktion aller der vorhandenen elektrischen Schalter ermöglicht. Ein häufig auftretender Fehler ist bei Schaltern ein sogenannter "klebender Schalter", bei welchem aus einem geschlossenen Schaltzustand in einen offenen Schaltzustand nicht geschaltet werden kann. Durch die erfindungsgemäße Schaltungsanordnung wird somit ermöglicht, dass durch einen statischen L-Pegel, also das Neutralpotential, an dem Testeingang der Steuereinheit die Fehlerfunktion "klebender Schalter" eines der separaten Schalters beim offenen gemeinsamen Schalter erkannt werden kann. Überdies gewährleistet die Schaltungsanordnung eine Erkennung des "klebenden" gemeinsamen Schalters im Falle, dass sich die separaten Schalter in ihren offenen Schaltzuständen befinden, was insbesondere durch einen AC-Pegel, also das Netzpotential, an dem Testeingang der Steuereinheit sichtbar wird.

Vorzugsweise ist der Rückkoppelpol zwischen einem ersten der elektrischen Verbraucher, insbesondere dem Elektromotor, und einem diesen zugeordneten separaten Schalter ausgebildet.

In einer Ausführungsform ist der Testeingang der Steuereinheit mit einer Gleichspannungsquelle gekoppelt. Insbesondere kann die Gleichspannungsquelle zur Erzeugung einer Gleichspannung von 5 Volt, 9 Volt oder 12 Volt ausgebildet sein. Hierdurch wird im Hinblick auf die Sicherheit und eine ordnungsgemäße Einschaltbedienung ein Erkennen aller offenen Schalter durch einen durch die Gleichspannungsquelle bedingten H-Pegel, also eine Gleichspannung, an dem Testeingang der Steuereinheit erreicht. Insbesondere können Diagnoseschritte zur Fehlererkennung vor Inbetriebnahme des Hausgeräts ausgeführt werden. Darüber hinaus können die Schaltzustände der elektrischen Schalter vorzugsweise im Betrieb auf Plausibilität geprüft werden. Insbesondere nach Erkennen eines Fehlers oder nicht gegebener Plausibilität wird das Hausgerät in einen sicheren Zustand durch Öffnen aller elektrischen Schalter gebracht.

Vorzugsweise ist der Gleichspannungsquelle ein Spannungsteiler mit zwei Ohmschen Widerständen und einem zwischen den Widerständen angeordneten Spannungsteilerpol zugeordnet, wobei ein erster der Widerstände zwischen dem Rückkoppelpol und dem Spannungsteilerpol geschaltet ist, und ein zweiter der Widerstände zwischen der Gleichspannungsquelle und dem Spannungsteilerpol geschaltet ist. Insbesondere ist dann der Spannungsteilerpol mit dem Testeingang der Steuereinheit zumindest mittelbar gekoppelt. Durch den der Gleichspannungsquelle zugeordneten Spannungsteiler wird erreicht, dass keine zu hohe Gleichspannung an dem Testeingang der Steuereinheit anliegen kann. Insbesondere sind die beiden Widerstände des Spannungsteilers derart ausgebildet, dass bei allen offenen Schaltern an dem Testeingang der Steuereinheit eine Gleichspannung von zwei Drittel der von der Gleichspannungsquelle erzeugten Spannung anliegt.

In einer Ausführungsform ist ein Gleichrichter mit einer Diode zwischen dem Rückkoppelpol und dem Testeingang der Steuereinheit geschaltet. Bei der Ausführungsform mit dem Spannungsteiler kann der Gleichrichter insbesondere zwischen dem Spannungsteilerpol und dem Testeingang der Steuereinheit geschaltet sein. Durch den geschickten Einsatz des Gleichrichters einschließlich einer Diode wird gewährleistet, dass an dem Testeingang der Steuereinheit ausschließlich eine gleichgerichtete Spannung anliegen kann. Insbesondere bei einem geschlossenen, dem Netzpotential zugeordneten Schalter wird hierdurch erreicht, dass der an dem Testeingang auftretende AC-Pegel gleichgerichtet wird.

Der soeben erwähnte Gleichrichter mit Diode ist auch zu verstehen als Symbol für eine dem Testeingang zugeordnete Schutzbeschaltung, welche nicht notwendigerweise außerhalb der Steuereinheit realisiert sein muss. Insbesondere kann die Diode und ein evtl. mit dieser verbundener Überspannungsschutz als interner Schaltungsteil eines Halbleiterbausteins, der den Testeingang der Steuereinheit definiert, ausgeführt sein.

Alternativ kann der Testeingang der Steuereinheit zum Betrieb mit Wechselspannung ausgebildet sein.

Vorzugsweise ist jedem der elektrischen Schalter ein Steuerelement zugeordnet, welches mit der Steuereinheit gekoppelt und zum Schließen und/oder Öffnen des zugeordneten Schalters aufgrund eines Signals von der Steuereinheit ausgebildet ist, wobei die elektrischen Schalter vorzugsweise als Relais ausgebildet sind. Hierdurch wird im Hinblick auf energieeffizientes und sicheres Betreiben des Hausgeräts gewahrleistet, dass die elektrischen Schalter auf technisch einfache Weise ausschließlich durch ein Bestromen zugeordneter Steuerelemente von Seiten der Steuereinheit hin- und hergeschaltet werden können.

Ein erfindungsgemäßes Verfahren ist zum Betreiben eines Hausgeräts, insbesondere zur Pflege von Wäschestücken, mit einer Schaltungsanordnung ausgelegt. Dabei ist eine Steuereinheit vorgesehen, mittels welcher Prozesse des Hausgeräts gesteuert werden, wobei die Schaltungsanordnung mindestens zwei elektrische Verbraucher, die zumindest einen Elektromotor und eine Heizung umfassen, aufweist, welche mit einem ersten Eingangsanschluss eines Eingangs der Schaltungsanordnung über einen, von der Steuereinheit ansteuerbaren gemeinsamen elektrischen Schalter bedarfsabhängig gekoppelt werden Die mindestens zwei elektrischen Verbraucher werden überdies mit einem zweiten Eingangsanschluss des Eingangs über jeweils einen, von der Steuereinheit ansteuerbaren separaten elektrischen Schalter bedarfsabhängig gekoppelt, wobei zwischen dem gemeinsamen Schalter und einem der separaten Schalter ein Rückkoppelpol ausgebildet wird, welcher mit einem Testeingang der Steuereinheit gekoppelt wird.

Bei dem Verfahren wird der Rückkoppelpol zwischen einem ersten der elektrischen Verbraucher, insbesondere dem Elektromotor und einem diesen zugeordneten separaten Schalter ausgebildet.

Vorzugsweise wird der Testeingang der Steuereinheit mit einer Gleichspannungsquelle gekoppelt.

In einer Ausführungsform des Verfahrens wird der Gleichspannungsquelle ein Spannungsteiler mit drei Ohmschen Widerständen und einem zwischen den Widerständen angeordneten Spannungsteilerpol zugeordnet, wobei ein erster der Widerstände zwischen dem Rückkoppelpol und dem Spannungsteilerpol geschaltet wird, und ein zweiter der Widerstände zwischen der Gleichspannungsquelle und dem Spannungsteilerpol geschaltet wird.

Bevorzugt wird ein Gleichrichter mit einer Diode zwischen dem Spannungsteilerpol und dem Testeingang der Steuereinheit geschaltet, mittels welchem eine Wechselspannung gerichtet wird.

Alternativ wird bei dem Verfahren der Testeingang der Steuereinheit mit Wechselspannung beaufschlagt, wobei der Spannungsteilerpol direkt mit dem Testeingang gekoppelt ist. In solchem Fall ist eine Diode zwischen dem Spannungsteilerpol und dem Testeingang weder realisierbar noch erforderlich. Es wäre denkbar, zwischen den Testeingang und das Massepotential eine Kombination gegeneinander geschalteter Zenerdioden als Spannungsbegrenzer zu Schalten - falls die Steuereinheit eine entsprechende Schutzschaltung nicht schon als interne Komponente enthält.

Bei dem Verfahren wird jedem der elektrischen Schalter ein Steuerelement zugeordnet, welches mit der Steuereinheit gekoppelt und zum Schließen und/oder Öffnen des zugeordneten Schalters aufgrund eines Signals von der Steuereinheit ausgebildet wird.

Die elektrischen Schalter werden vorzugsweise als Relais ausgebildet.

Vorteilhafte Ausgestaltungen der erfindungsgemäßen Schaltungsanordnung und deren Vorteile gelten entsprechend für das erfindungsgemäße Verfahren.

Weitere Vorteile, Merkmale und Einzelheiten der Erfindung ergeben sich aus der nachfolgenden Beschreibung einzelner bevorzugter Ausführungsbeispiele sowie anhand der Zeichnungen. Dabei zeigen:
- Fig. 1: eine Schaltungsanordnung zum Betreiben eines Hausgeräts gemäß einem ersten Ausführungsbeispiel;
- Fig. 2: eine Schaltungsanordnung gemäß einem zweiten Ausführungsbeispiel.

In den Figuren sind gleiche bzw. funktionsgleiche Elemente mit gleichen Bezugszeichen versehen.

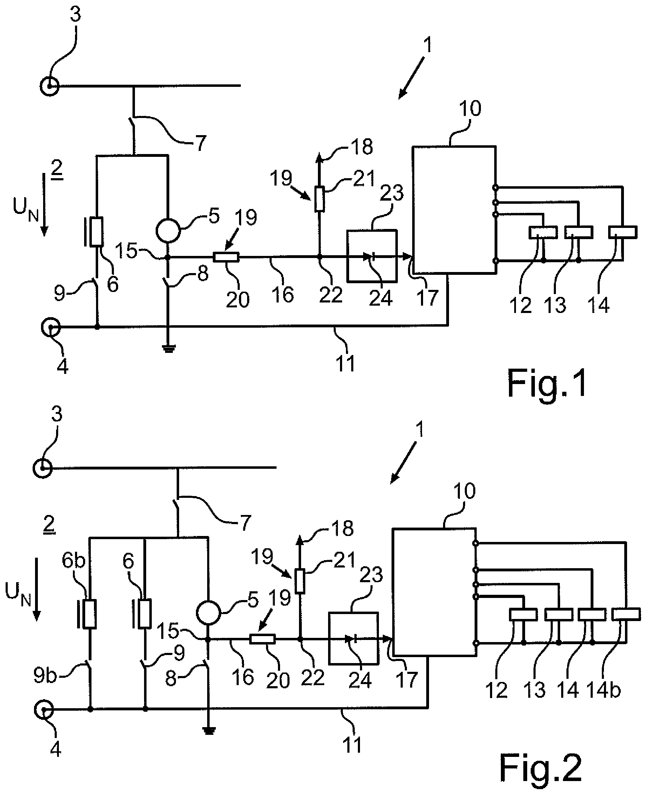

Eine in Fig. 1 dargestellte Schaltungsanordnung 1 ist zum Betreiben eines Hausgeräts ausgebildet. Das Hausgerät kann dabei eine Waschmaschine, ein Trockner oder ein Waschtrockner sein.

Die Schaltungsanordnung 1 umfasst einen Eingang 2, welcher einen ersten Eingangsanschluss 3 sowie einen zweiten Eingangsanschluss 4 aufweist. Ist die Schaltungsanordnung 1 an ein Versorgungsnetz angeschlossen, so liegt an dem Eingang 2 eine Netzspannung U_{N} an. Dabei ist der erste Eingangsanschluss 3 mit einem Netzpotential, insbesondere 230 Volt, gekoppelt, wobei der zweite Eingangsanschluss 4 mit einem Neutralpotential gekoppelt ist.

Vorliegend umfasst die Schaltungsanordnung 1 zwei elektrische Verbraucher, einen Elektromotor 5 sowie eine Heizung 6. Dabei ist der Elektromotor 5 zum Antreiben einer nicht dargestellten Trommel des Hausgeräts ausgebildet. Überdies ist die Heizung 6 zum Aufheizen von Wasser und/oder von Luft in einem Innenraum des Hausgeräts, insbesondere der Trommel, ausgebildet.

Der Elektromotor 5 und die Heizung 6 sind mit dem ersten Eingangsanschluss 3 des Eingangs 2 der Schaltungsanordnung 1 über einen gemeinsamen elektrischen Schalter 7 gekoppelt, welcher vorliegend als ein gemeinsames Relais ausgebildet ist. Darüber hinaus ist dem Elektromotor 5 und der Heizung 6 jeweils ein separater elektrischer Schalter 8, 9 zugeordnet, über welchen der Elektromotor 5 bzw. die Heizung 6 mit dem zweiten Eingangsanschluss 4 des Eingangs 2 gekoppelt sind. Vorliegend sind die separaten Schalter 8, 9 als Relais ausgebildet.

Die Schaltungsanordnung 1 umfasst ferner eine Steuereinheit 10, welche zum Steuern von Prozessen des Hausgeräts ausgebildet ist. Die Steuereinheit 10 ist mit dem zweiten Eingangsanschluss 4 des Eingangs 2 über eine Leitung 11 verbunden und somit beim Vorliegen der Netzspannung U_{N} mit dem Neutralpotential gekoppelt.

Darüber hinaus sei erwähnt, dass dem gemeinsamen Schalter 7 als auch den beiden separaten Schaltern 8, 9 jeweils ein Steuerelement 12, 13, 14 zugeordnet ist, welches mit der Steuereinheit 10 gekoppelt und von dieser ansteuerbar ist. So ist die Steuereinheit 10 in der Lage, die elektrischen Schalter 7, 8, 9 durch ein einfaches Bestromen des zugeordneten Steuerelements 12, 13, 14 zu schließen bzw. zu öffnen.

Vorliegend richtet sich das Interesse auf eine Erkennung der ordnungsgemäßen Funktion der elektrischen Schalter 7, 8, 9. Hierzu ist im Beispiel zwischen dem Elektromotor 5 und dem diesem zugeordneten separaten Schalter 8 ein Rückkoppelpol 15 ausgebildet, welcher über einen Rückkanal 16 mit einem Testeingang 17 der Steuereinheit 10 gekoppelt ist. Dabei ist eine Gleichspannungsquelle 18 vorgesehen, welche vorliegend als eine 5-Volt-Gleichspannungsquelle ausgebildet ist. Der Gleichspannungsquelle 18 ist ferner ein Spannungsteiler 19 zugeordnet, welcher einen ersten Ohmschen Widerstand 20 sowie einen zweiten Ohmschen Widerstand 21 aufweist. Dabei ist der erste Widerstand 20 zwischen dem Rückkoppelpol 15 und einem Spannungsteilerpol 22 geschaltet, wobei der zweite Widerstand 21 zwischen der Gleichspannungsquelle 18 und dem Spannungsteilerpol 22 geschaltet ist. Darüber hinaus sei angemerkt, dass der Spannungsteilerpol 22 mit dem Testeingang 17 der Steuereinheit 10 über einen Gleichrichter 23 einschließlich einer Diode 24 gekoppelt ist.

Wenn die Steuereinheit 10 an ihrem Testeingang 17 eine interne Schutzschaltung gegen Überspannung und Verpolung aufweist, kann der Gleichrichter 23 mit der Diode 24 entfallen und der Spannungsteilerpol 22 unmittelbar mit dem Testeingang 17 verbunden sein. Insoweit ist der Gleichrichter 23 auch als Symbol für eine interne Schutzschaltung der Steuereinheit 10 zu sehen. Eine Alternative zur mit Gleichstrom zu beaufschlagenden Steuereinheit 10 gemäß Figur 1 kann darin bestehen, eine mit Wechselstrom zu beaufschlagende Steuereinheit 10 vorzusehen. In diesem Fall hätte der Gleichrichter 23 ebenfalls zu entfallen.

Fig. 2 gibt die Schaltungsanordnung 1 gemäß einem zweiten Ausführungsbeispiel wieder. Die Schaltungsanordnung 1 gemäß dem zweiten Ausführungsbeispiel entspricht der gemäß dem ersten Ausführungsbeispiel, wobei ein Unterschied darin besteht, dass ein weiterer elektrischer Verbraucher, nämlich eine zweite Heizung 6b vorgesehen ist. Überdies weist die Schaltungsanordnung 1 gemäß dem zweiten Ausführungsbeispiel einen weiteren separaten Schalter 9b auf, über welchen die zweite Heizung 6b mit dem zweiten Eingangsanschluss 4 des Eingangs 2 der Schaltungsanordnung 1 gekoppelt ist. Somit ist die zweite Heizung 6b auf gleiche Weise wie die Heizung 6 und der Elektromotor 5 doppelseitig mit dem Eingang 2, einerseits über den gemeinsamen Schalter 7 und andererseits über den separaten Schalter 9b koppelbar. Darüber hinaus umfasst die Schaltungsanordnung 1 gemäß dem zweiten Ausführungsbeispiel ein weiteres Steuerelement 14b, welches mit der Steuereinheit 10 gekoppelt und von dieser ansteuerbar ist. So kann der weitere separate Schalter 9b durch ein Bestromen des Steuerelements 14b von der Steuereinheit 10 in seinen offenen bzw. geschlossenen Schaltzustand gebracht werden.

Nachfolgend wird die bevorzugte Funktionsweise der Schaltungsanordnung 1 gemäß dem ersten und dem zweiten Ausführungsbeispiel näher erläutert. Ziel ist es eine Fehlerfunktion der elektrischen Schalter 7, 8, 9, 9b, und insbesondere einen "klebenden Schalter" zu detektieren. Wird die Schaltungsanordnung 1 an das Versorgungsnetz angeschlossen, so dass am Eingang 2 die Netzspannung U_{N} anliegt, so kann das Hausgerät in Betrieb genommen werden. Zunächst sind der gemeinsame Schalter 7 sowie die separaten Schalter 8, 9, 9b geöffnet, so dass durch die elektrischen Verbraucher 5, 6, 6b kein Strom fließen kann. Nun werden Diagnoseschritte zur Fehlererkennung vor der Inbetriebnahme des Hausgeräts durchgeführt. Sind alle elektrischen Schalter 7, 8, 9, 9b geöffnet, so liegt an dem Testeingang 17 der Steuereinheit 10 eine von der Gleichspannungsquelle 18 stammende Gleichspannung an. Hierdurch wird erkannt, dass sich alle Schalter 7, 8, 9, 9b in ihren offenen Schaltzuständen befinden. Im nächsten Schritt wird der gemeinsame Schalter 7 geprüft. Hierzu bleiben die separaten Schalter 8, 9, 9b geöffnet und der gemeinsame Schalter 7 wird von der Steuereinheit 10 angesteuert. Wird ein "klebender" gemeinsamer Schalter 7 erkannt, so liegt an dem Testeingang 17 der Steuereinheit 10 eine mittels des Gleichrichters 23, und genauer mittels der Diode 24, gleichgerichtete Spannung an, welche über den ersten Eingangsanschluss 3 und den klebenden gemeinsamen Schalter 7 induziert wird. Weist hingegen der gemeinsame Schalter 7 keine Fehlerfunktion auf, so kann dieser in seinen offenen Schaltzustand gebracht werden, was durch eine von der Gleichspannungsquelle 18 stammende Gleichspannung am Testeingang 17 der Steuereinheit 10 sichtbar wird. Im nächsten Schritt werden die separaten Schalter 8, 9, 9b geprüft. Weist einer der separaten Schalter 8, 9, 9b eine Fehlerfunktion "klebender Schalter" auf, so wird dies über einen statischen L-Pegel, also das Neutralpotential, am Testeingang 17 der Steuereinheit 10 erkannt. Nach Abschließen der Diagnoseschritte wird das Hausgerät in Betrieb genommen, wobei die Schaltzustände einzelner Schalter 7, 8, 9, 9b im Betrieb auf Plausibilität geprüft werden können.

Hinsichtlich des Gleichrichters 23 in der Schaltung gemäß Figur 2 gilt das zur entsprechenden Komponente in der Schaltung gemäß Figur 1 gesagte.

In vorteilhafter Weise ermöglicht die Schaltungsanordnung 1 eine Erkennung einer Fehlerfunktion aller der Schalter 7, 8, 9, 9b, und zwar durch Einsatz eines einzigen Rückkanals 16. Somit findet die Abfrage der Fehlerfunktion am Ende der Fehlerkette statt. Hierdurch werden einfachere Tests der Fehlermodelle ermöglicht.

## Patentansprüche

1. Hausgerät, insbesondere zur Pflege von Wäschestücken, mit einer Schaltungsanordnung (1) zum Betreiben des Hausgeräts, mit einer Steuereinheit (10) zum Steuern von Prozessen des Hausgeräts und mit mindestens zwei elektrischen Verbrauchern (5, 6, 6b), welche zumindest eine Heizung (6, 6b) umfassen, wobei die Heizung doppelseitig mit einem Eingang der Schaltungsanordnung gekoppelt ist, wobei die Heizung mit einem ersten Eingangsanschluss (3) des Eingangs (2) der Schaltungsanordnung (1) über einen ersten, von der Steuereinheit (10) ansteuerbaren elektrischen Schalter (7) und mit einem zweiten Eingangsanschluss (4) des Eingangs (2) über einen von der Steuereinheit (10) ansteuerbaren separaten elektrischen Schalter (8, 9, 9b) gekoppelt ist, wobei zwischen dem ersten Schalter (7) und dem separaten Schalter (8, 9, 9b) ein Rückkoppelpol (15) ausgebildet ist, welcher mit einem Testeingang (17) der Steuereinheit (10) gekoppelt ist, **dadurch gekennzeichnet, dass** die elektrischen Verbraucher (5, 6, 6b) zusätzlich mindestens einen Elektromotor (5) umfassen, der doppelseitig mit dem Eingang der Schaltungsanordnung gekoppelt ist und der mit dem ersten Eingangsanschluss (3) über den ersten, von der Steuereinheit (10) ansteuerbaren elektrischen Schalter (7) und mit dem zweiten Eingangsanschluss (4) über einen weiteren, von der Steuereinheit (10) ansteuerbaren separaten elektrischen Schalter (8, 9, 9b) gekoppelt ist wobei die Verbraucher (5, 6, 6b) über den ersten Schalter (7) als ein gemeinsamer, von der Steuereinheit (10) ansteuerbarer Schalter mit dem ersten Eingangsanschluss (3) und jeweils über die separaten Schalter (8, 9, 9b) mit dem zweiten Eingangsanschluss (4) gekoppelt sind.

2. Hausgerät nach Anspruch 1, bei welchem der Rückkoppelpol (15) zwischen einem ersten elektrischen Verbraucher, insbesondere dem Elektromotor (5), und einem dem Verbraucher zugeordneten separaten Schalter (8) ausgebildet ist.

3. Hausgerät nach Anspruch 1 oder 2, bei welchem der Testeingang (17) der Steuereinheit (10) mit einer Gleichspannungsquelle (18) gekoppelt ist.

4. Hausgerät nach Anspruch 3, bei welchem ein Spannungsteiler (19) mit zwei Ohmsehen Widerständen (20, 21) und einem zwischen den Widerständen (20, 21) angeordneten Spannungsteilerpol (22) der Gleichspannungsquelle (18) zugeordnet ist, wobei ein erster der Widerstände (20) zwischen dem Rückkoppelpol (15) und dem Spannungsteilerpol (22) geschaltet ist, und ein zweiter der Widerstände (21) zwischen der Gleichspannungsquelle (28) und dem Spannungsteilerpol (22) geschaltet ist.

5. Hausgerät nach Anspruch 4, bei welchem ein Gleichrichter (23) mit einer Diode (24) zwischen dem Spannungsteilerpol (22) und dem Testeingang (17) der Steuereinheit geschaltet ist.

6. Hausgerät nach Anspruch 4, bei welchem der Testeingang (17) der Steuereinheit (10) zum Betrieb mit Wechselspannung ausgebildet und der Spannungsteilerpol (22) direkt mit dem Testeingang (17) gekoppelt ist.

7. Hausgerät nach einem der vorhergehenden Ansprüche, bei welchem jedem der elektrischen Schalter (7, 8, 9, 9b) ein Steuerelement (12, 13, 14, 14b) zugeordnet ist, welches mit der Steuereinheit (10) gekoppelt und zum Schließen und/oder Öffnen des zugeordneten Schalters (7, 8, 9, 9b) aufgrund eines Signals von der Steuereinheit (10) ausgebildet ist

8. Hausgerät nach einem der vorhergehenden Ansprüche, bei welchem die elektrischen Schalter (7, 8, 9, 9b) als Relais ausgebildet sind.

9. Verfahren zum Betreiben eines Hausgeräts, insbesondere zur Pflege von Wäschestücken, mit einer Schaltungsanordnung (1), bei welcher mittels einer Steuereinheit Prozesse des Hausgeräts gesteuert werden, wobei die Schaltungsanordnung (1) mindestens zwei elektrische Verbraucher aufweist, welche zumindest eine Heizung (6, 6b) umfassen, wobei die Heizung doppelseitig mit einem Eingang der Schaltungsanordnung gekoppelt ist, wobei die Heizung mit einem ersten Eingangsanschluss (3) des Eingangs (2) der Schaltungsanordnung über einen, von der Steuereinheit ansteuerbaren ersten elektrischen Schalter (7) und mit einem zweiten Eingangsanschluss (4) des Eingangs (2) über einen, von der Steuereinheit (1ß) ansteuerbaren separaten elektrischen Schalter (8, 9, 9b) bedarfsabhängig gekoppelt wird, wobei die Steuereinheit (10) einen Testeingang (17) aufweist und zwischen dem ersten Schalter (7) und einem der separaten Schalter (8, 9, 9b) ein Rückkoppelpol (15) ausgebildet wird, welcher mit dem Testeingang (17) der Steuereinheit (10) gekoppelt wird, **dadurch gekennzeichnet, dass** die elektrischen Verbraucher (5, 6, 6b) zusätzlich zumindest einen Elektromotor (5) umfassen, der doppelseitig mit dem Eingang der Schaltungsanordnung gekoppelt ist und der mit dem ersten Eingangsanschluss (3) über den ersten, von der Steuereinheit (10) ansteuerbaren elektrischen Schalter (7) und mit dem zweiten Eingangsanschluss (4) über einen, von der Steuereinheit (10) ansteuerbaren separaten elektrischen Schalter (8, 9, 9b) gekoppelt wird, dass der Testeingang (17) mit einer Gleichspannungsquelle (18) gekoppelt wird, wobei die Verbraucher (5, 6, 6b) über den ersten Schalter (7) als ein gemeinsamer, von der Steuereinheit (10) ansteuerbarer Schalter mit dem ersten Eingangsanschluss (3) und jeweils über die separaten Schalter (8, 9, 9b) mit dem zweiten Eingangsanschluss (4) gekoppelt werden.

10. Verfahren nach Anspruch 9, bei welchem der Rückkoppelpol (15) zwischen einem ersten elektrischen Verbraucher, insbesondere dem Elektromotor (5), und einem dem Verbraucher zugeordneten separaten Schalter (8) ausgebildet wird.

11. Verfahren nach Anspruch 9 oder 10, bei welchem der Testeingang (17) der Steuereinheit (10) mit einer Gleichspannungsquelle (18) gekoppelt wird.

12. Verfahren nach Anspruch 11, bei welchem ein Spannungsteiler (19) mit zwei Ohmschen Widerständen (20, 21) und einem zwischen den Widerständen (20, 21) angeordneten Spannungsteilerpol (22) der Gleichspannungsquelle (18) zugeordnet wird, wobei ein erster der Widerstände (20) zwischen dem Rückkoppelpol (15) und dem Spannungsteilerpol (22) geschaltet wird, und ein zweiter der Widerstände (21) zwischen der Gleichspannungsquelle (18) und dem Spannungsteilerpol (22) geschaltet wird.

13. Verfahren nach Anspruch 12, bei welchem ein Gleichrichter (23) mit einer Diode (24) zwischen dem Spannungsteilerpol (22) und dem Testeingang (17) der Steuereinheit (10) geschaltet wird, mittels welchem eine Wechselspannung gerichtet wird.

14. Verfahren nach Anspruch 12, bei welchem der Testeingang (17) der Steuereinheit (10) mit Wechselspannung beaufschlagt wird, wobei der Spannungsteilerpol (22) direkt mit dem Testeingang (17) gekoppelt ist.

15. Verfahren nach einem der Ansprüche 9 bis 14, bei welchem jedem der elektrischen Schalter (8, 9, 9b) ein Steuerelement zugeordnet wird, welches mit der Steuereinheit (10) gekoppelt und zum Schließen und/oder Öffnen des zugeordneten Schalters aufgrund eines Signals von der Steuereinheit (10) ausgebildet wird.

16. Verfahren nach einem der Ansprüche 9 bis 15, bei welchem die elektrischen Schalter (7, 8, 9, 9b) als Relais ausgebildet werden.

## Claims

1. Household appliance, in particular for the treatment of laundry items, having a circuit arrangement (1) for operating the household appliance, having a control unit (10) for controlling processes of the household appliance and having at least two electrical loads (5, 6, 6b), which comprise at least one heater (6, 6b), wherein the heater is coupled on both sides to an input of the circuit arrangement, wherein the heater is coupled to a first input terminal (3) of the input (2) of the circuit arrangement (1) via a first electrical switch (7) which can be activated by the control unit (10) and to a second input terminal (4) of the input (2) via a separate electrical switch (8, 9, 9b) which can be activated by the control unit (10), wherein a feedback pole (15) is embodied between the first switch (7) and the separate switch (8, 9, 9b), which is coupled to a test input (17) of the control unit (10), **characterised in that** the electrical loads (5, 6, 6b) additionally comprise at least one electric motor (5), which is coupled on both sides to the input of the circuit arrangement and which is coupled to the first input terminal (3) via the first electrical switch (7) which can be activated by the control unit (10) and to the second input terminal (4) via a further separate electrical switch (8, 9, 9b) which can be activated by the control unit (10), wherein the loads (5, 6, 6b) are coupled via the first switch (7) as a joint switch which can be activated by the control unit (10) to the first input terminal (3) and in each case via the separate switches (8, 9, 9b) to the second input terminal (4).

2. Household appliance according to claim 1, in which the feedback pole (15) is embodied between a first electrical load, in particular the electric motor (5), and a separate switch (8) assigned to the load.

3. Household appliance according to claim 1 or 2, in which the test input (17) of the control unit (10) is coupled to a direct voltage source (18).

4. Household appliance according to claim 3, in which a voltage divider (19) with two ohmic resistances (20, 21) and a voltage divider pole (22) arranged between the resistances (20, 21) is assigned to the direct voltage source (18), wherein a first of the resistances (20) is switched between the feedback pole (15) and the voltage divider pole (22), and a second of the resistances (21) is switched between the direct voltage source (28) and the voltage divider pole (22).

5. Household appliance according to claim 4, in which a rectifier (23) with a diode (24) is switched between the voltage divider pole (22) and the test input (17) of the control unit.

6. Household appliance according to claim 4, in which the test input (17) of the control unit (10) is embodied for operation with alternating voltage and the voltage divider pole (22) is coupled directly to the test input (17).

7. Household appliance according to one of the preceding claims, in which each of the electrical switches (7, 8, 9, 9b) is assigned a control element (12, 13, 14, 14b), which is coupled to the control unit (10) and is embodied for closing and/or opening the assigned switch (7, 8, 9, 9b) on account of a signal from the control unit (10).

8. Household appliance according to one of the preceding claims, in which the electrical switches (7, 8, 9, 9b) are embodied as a relay.

9. Method for operating a household appliance, in particular for the treatment of laundry items, with a circuit arrangement (1), in which processes of the household appliance are controlled using a control unit, wherein the circuit arrangement (1) has at least two electrical loads, which comprise at least one heater (6, 6b), wherein the heater is coupled on both sides to an input of the circuit arrangement, wherein the heater is coupled to a first input terminal (3) of the input (2) of the circuit arrangement via a first electrical switch (7) which can be activated by the control unit and to a second input terminal (4) of the input (2) via a separate electrical switch (8, 9, 9b) which can be activated by the control unit (10) depending on requirements, wherein the control unit (10) has a test input (17) and a feedback pole (15) is embodied between the first switch (7) and one of the separate switches (8, 9, 9b), said feedback pole (15) being coupled to the test input (17) of the control unit (10), **characterised in that** the electrical loads (5, 6, 6b) additionally comprise at least one electric motor (5), which is coupled on both sides to the input of the circuit arrangement and which is coupled to the first input terminal (3) via the first electrical switch (7) which can be activated by the control unit (10) and to the second input terminal (4) via a separate electrical switch (8, 9, 9b) which can be activated by the control unit (10), that the test input (17) is coupled to a direct voltage source (18), wherein the loads (5, 6, 6b) are coupled via the first switch (7) as a joint switch which can be activated by the control unit (10) to the first input terminal (3) and in each case via the separate switches (8, 9, 9b) to the second input terminal (4).

10. Method according to claim 9, in which the feedback pole (15) is embodied between a first electrical load, in particular the electric motor (5), and a separate switch (8) assigned to the load.

11. Method according to claim 9 or 10, in which the test input (17) of the control unit (10) is coupled to a direct voltage source (18).

12. Method according to claim 11, in which a voltage divider (19) with two ohmic resistances (20, 21) and a voltage divider pole (22) arranged between the resistances (20, 21) is assigned to the direct voltage source (18), wherein a first of the resistances (20) is switched between the feedback pole (15) and the voltage divider pole (22), and a second of the resistances (21) is switched between the direct voltage source (18) and the voltage divider pole (22).

13. Method according to claim 12, in which a rectifier (23) with a diode (24) is switched between the voltage divider pole (22) and the test input (17) of the control unit (10), by means of which an alternating voltage is regulated.

14. Method according to claim 12, in which alternating voltage is applied to the test input (17) of the control unit (10), wherein the voltage divider pole (22) is coupled directly to the test input (17).

15. Method according to one of claims 9 to 14, in which each of the electrical switches (8, 9, 9b) is assigned a control element which is coupled to the control unit (10) and is embodied for closing and/or opening the assigned switch on account of a signal from the control unit (10).

16. Method according to one of claims 9 to 15, in which the electrical switches (7, 8, 9, 9b) are embodied as a relay.

## Revendications

1. Appareil ménager, notamment pour l'entretien de pièces de linge, comprenant un agencement de circuit (1) pour le fonctionnement de l'appareil ménager, comprenant une unité de commande (10) pour la commande de processus de l'appareil ménager, et comprenant au moins deux consommateurs électriques (5, 6, 6b) lesquels comprennent au moins un dispositif de chauffage (6, 6b), le dispositif de chauffage étant couplé de deux côtés à une entrée de l'agencement de circuit, le dispositif de chauffage étant couplé à une première borne d'entrée (3) de l'entrée (2) de l'agencement de circuit (1) par l'intermédiaire d'un premier commutateur électrique (7) commandable par l'unité de commande (10), et à une deuxième borne d'entrée (4) de l'entrée (2) par l'intermédiaire d'un commutateur électrique (8, 9, 9b) séparé, commandable par l'unité de commande (10), un pôle à rétroaction (15) étant réalisé entre le premier commutateur (7) et le commutateur séparé (8, 9, 9b), lequel pôle à rétroaction est couplé à une entrée de test (17) de l'unité de commande (10), **caractérisé en ce que** les consommateurs électriques (5, 6, 6b) comprennent en plus au moins un moteur électrique (5) qui est couplé de deux côtés à l'entrée de l'agencement de circuit et qui est couplé à la première borne d'entrée (3) par l'intermédiaire du premier commutateur électrique (7) commandable par l'unité de commande (10), et à la deuxième borne d'entrée (4) par l'intermédiaire d'un commutateur électrique (8, 9, 9b) supplémentaire séparé, commandable par l'unité de commande (10), les consommateurs (5, 6, 6b) étant couplés à la première borne d'entrée (3) par l'intermédiaire du premier commutateur (7) en tant qu'un commutateur commun commandable par l'unité de commande (10), et à la deuxième borne d'entrée (4) respectivement par l'intermédiaire des commutateurs séparés (8, 9, 9b).

2. Appareil ménager selon la revendication 1, dans lequel le pôle à rétroaction (15) est réalisé entre un premier consommateur électrique, notamment le moteur électrique (5), et un commutateur (8) séparé associé au consommateur.

3. Appareil ménager selon la revendication 1 ou 2, dans lequel l'entrée de test (17) de l'unité de commande (10) est couplée à une source de tension continue (18).

4. Appareil ménager selon la revendication 3, dans lequel un diviseur de tension (19) doté de deux résistances ohmiques (20, 21) et d'un pôle de diviseur de tension (22) disposé entre les résistances (20, 21) est associé à la source de tension continue (18), une première des résistances (20) étant connectée entre le pôle à rétroaction (15) et le pôle de diviseur de tension (22), et une deuxième des résistances (21) étant connectée entre la source de tension continue (28) et le pôle de diviseur de tension (22).

5. Appareil ménager selon la revendication 4, dans lequel un redresseur (23) muni d'une diode (24) est connecté entre le pôle de diviseur de tension (22) et l'entrée de test (17) de l'unité de commande.

6. Appareil ménager selon la revendication 4, dans lequel l'entrée de test (17) de l'unité de commande (10) est réalisée pour le fonctionnement avec la tension alternative, et dans lequel le pôle de diviseur de tension (22) est directement couplé à l'entrée de test (17).

7. Appareil ménager selon l'une quelconque des revendications précédentes, dans lequel un élément de commande (12, 13, 14, 14b) est associé à chacun des commutateurs électriques (7, 8, 9, 9b), lequel élément de commande est couplé à l'unité de commande (10) et est réalisé pour fermer et/ou ouvrir le commutateur associé (7, 8, 9, 9b) en raison d'un signal de l'unité de commande (10).

8. Appareil ménager selon l'une quelconque des revendications précédentes, dans lequel les commutateurs électriques (7, 8, 9, 9b) sont réalisés comme des relais.

9. Procédé de fonctionnement d'un appareil ménager, notamment pour l'entretien de pièces de linge, comprenant un agencement de circuit (1), dans lequel des processus de l'appareil ménager sont commandés au moyen d'une unité de commande, l'agencement de circuit (1) présentant au moins deux consommateurs électriques lesquels comprennent au moins un dispositif de chauffage (6, 6b), le dispositif de chauffage étant couplé, en fonction des besoins, de deux côtés à une entrée de l'agencement de circuit, le dispositif de chauffage étant couplé à une première borne d'entrée (3) de l'entrée (2) de l'agencement de circuit par l'intermédiaire d'un premier commutateur électrique (7) commandable par l'unité de commande, et à une deuxième borne d'entrée (4) de l'entrée (2) par l'intermédiaire d'un commutateur électrique (8, 9, 9b) séparé, commandable par l'unité de commande (10), l'unité de commande (10) présentant une entrée de test (17), et un pôle à rétroaction (15) étant réalisé entre le premier commutateur (7) et l'un des commutateurs séparés (8, 9, 9b), lequel pôle à rétroaction est couplé à l'entrée de test (17) de l'unité de commande (10), **caractérisé en ce que** les consommateurs électriques (5, 6, 6b) comprennent en plus au moins un moteur électrique (5) qui est couplé de deux côtés à l'entrée de l'agencement de circuit et qui est couplé à la première borne d'entrée (3) par l'intermédiaire du premier commutateur électrique (7) commandable par l'unité de commande (10), et à la deuxième borne d'entrée (4) par l'intermédiaire d'un commutateur électrique (8, 9, 9b) séparé, commandable par l'unité de commande (10), **en ce que** l'entrée de test (17) est couplée à une source de tension continue (18), les consommateurs (5, 6, 6b) étant couplés à la première borne d'entrée (3) par l'intermédiaire du premier commutateur (7) en tant qu'un commutateur commun commandable par l'unité de commande (10), et à la deuxième borne d'entrée (4) respectivement par l'intermédiaire des commutateurs séparés (8, 9, 9b).

10. Procédé selon la revendication 9, dans lequel le pôle à rétroaction (15) est réalisé entre un premier consommateur électrique, notamment le moteur électrique (5), et un commutateur (8) séparé associé au consommateur.

11. Procédé selon la revendication 9 ou 10, dans lequel l'entrée de test (17) de l'unité de commande (10) est couplée à une source de tension continue (18).

12. Procédé selon la revendication 11, dans lequel un diviseur de tension (19) doté de deux résistances ohmiques (20, 21) et d'un pôle de diviseur de tension (22) disposé entre les résistances (20, 21) est associé à la source de tension continue (18), une première des résistances (20) étant connectée entre le pôle à rétroaction (15) et le pôle de diviseur de tension (22), et une deuxième des résistances (21) étant connectée entre la source de tension continue (18) et le pôle de diviseur de tension (22).

13. Procédé selon la revendication 12, dans lequel un redresseur (23) muni d'une diode (24) est connecté entre le pôle de diviseur de tension (22) et l'entrée de test (17) de l'unité de commande (10), au moyen duquel une tension alternative est redressée.

14. Procédé selon la revendication 12, dans lequel l'entrée de test (17) de l'unité de commande (10) est alimentée en tension alternative, le pôle de diviseur de tension (22) étant directement couplé à l'entrée de test (17).

15. Procédé selon l'une quelconque des revendications 9 à 14, dans lequel un élément de commande est associé à chacun des commutateurs électriques (8, 9, 9b), lequel élément de commande est couplé à l'unité de commande (10) et est réalisé pour fermer et/ou ouvrir le commutateur associé en raison d'un signal de l'unité de commande (10).

16. Procédé selon l'une quelconque des revendications 9 à 15, dans lequel les commutateurs électriques (7, 8, 9, 9b) sont réalisés comme des relais.
